Europäisches Patentamt

(19) European Patent Office

Office européen des brevets

(11) Numéro de publication: **0 200 255 B1**

(12) **FASCICULE DE BREVET EUROPEEN**

(45) Date de publication du fascicule du brevet: **11.07.90**

(51) Int. Cl.⁵: **G 11 C 8/00, H 03 K 19/013**

(21) Numéro de dépôt: **86200621.0**

(22) Date de dépôt: **14.04.86**

(54) **Etage de commutation du type darlington notamment pour décodeur de lignes d'une mémoire.**

(30) Priorité: **16.04.85 FR 8505702**

(43) Date de publication de la demande:
**05.11.86 Bulletin 86/45**

(45) Mention de la délivrance du brevet:
**11.07.90 Bulletin 90/28**

(84) Etats contractants désignés:
**DE FR GB IT NL**

(56) Documents cités:
**EP-A-0 011 700**
**FR-A-2 352 439**

**IEEE INTERNATIONAL SOLID-STATE CIRCUITS CONFERENCE, 15 février 1979, pages 108,109, New York, US; MASAAKI INADACHI et al.: "A 6ns 4Kb bipolar RAM using switched load resistor memory cell"**

(73) Titulaire: **PHILIPS COMPOSANTS**
**117, quai du Président Roosevelt**
**F-92130 Issy les Moulineaux (FR)**

(84) **FR**

(73) Titulaire: **N.V. Philips' Gloeilampenfabrieken**
**Groenewoudseweg 1**
**NL-5621 BA Eindhoven (NL)**

(84) **DE GB IT NL**

(72) Inventeur: **Imbert, Guy**
**SOCIETE CIVILE SPID 209 rue de l'Université**
**F-75007 Paris (FR)**
Inventeur: **Kwiatkowski, Jean-Claude**
**SOCIETE CIVILE SPID 209 rue de l'Université**
**F-75007 Paris (FR)**

(74) Mandataire: **Jacquard, Philippe et al**
**SOCIETE CIVILE S.P.I.D. 209, rue de l'Université**
**F-75007 Paris (FR)**

Courier Press, Leamington Spa, England.

## Description

La présente invention concerne un étage de commutation du type Darlington comportant un premier transistor dont la base, qui constitue l'entrée de l'étage est susceptible de recevoir un signal de commande dont la tension varie entre un niveau dit de sélection et un niveau dit de non-sélection, et dont l'émetteur attaque la base d'un deuxième transistor dont l'émetteur qui constitue la sortie de l'étage est susceptible d'être relié à une première source de courant lorsque ledit signal logique de commande est à son niveau de sélection et à une deuxième source de courant d'intensité plus faible que la première lorsque ledit signal logique de commande est à son niveau de non-sélection.

Un tel étage de commutation est couramment utilisé notamment comme étage de sortie à raison d'un par ligne d'un décodeur de lignes d'une mémoire rapide, la ligne sélectionnée étant parcourue par un courant de sélection important et les autres lignes par un courant de maintien considérablement plus faible.

Lors d'un changement d'adresse à l'entrée du décodeur, correspondant à la sélection d'une ligne différente, le courant dans la ligne qui se désélectionne passe pendant une durée appelée temps de désélection d'un niveau de courant élevé à un niveau considérablement plus faible et vice-versa pendant une durée appelée temps de sélection pour la ligne qui se sélectionne, les autres lignes restant au même niveau de courant.

Il est bien connu de l'homme de l'art que le temps de désélection est plus long que le temps de sélection.

Le temps d'accès mémoire est donc déterminé notamment par la capacité des étages de sortie du décodeur à assurer cette chute de courant dans le minimum de temps.

L'invention se propose de diminuer le temps de désélection des lignes en proposant un montage propre à faciliter l'évacuation des charges accumulées dans la base du deuxième transistor qui constitue le transistor de sortie du Darlington.

L'idée de base de l'invention consiste à mettre en oeuvre une source de courant auxiliaire pour chaque ligne ainsi que deux branches raccordées à celle-ci et agencées de manière à ce que le courant auxiliaire soit aiguillé majoritairement vers la première branche lorsque la ligne correspondante est sélectionnée, la première branche étant également raccordée à la base du transistor de sortie du Darlington. Ce courant passant dans la première branche est propre à activer la chute de courant en sortie du Darlington, de par sa contribution à l'évacuation des charges de la base du transistor de sortie du Darlington.

D'autre part, lorsque la ligne est désélectionnée, la majorité du courant auxiliaire passe dans la deuxième branche, ce qui permet d'augmenter le courant d'émetteur du transistor $T_2$ et d'éviter, ainsi qu'on le montrera par la suite, une trop forte diminution de l'écart entre le niveaux haut et bas sur l'émetteur du transistor de sortie du Darlington.

L'invention est ainsi caractérisée en ce que, entre la base du deuxième transistor et ladite source de courant auxiliaire dont l'intensité est comprise entre celle des deux premières sources de courant, sont disposées une première et une deuxième diode en série et dans le sens direct qui constituent ladite première branche, et en ce qu'entre l'émetteur du deuxième transistor et ladite source de courant auxiliaire est disposée une troisième diode dans le sens direct constituant ladite deuxième branche.

Le courant de la source de courant auxiliaire est avantageusement supérieur ou égal à 10% du courant de la deuxième source de courant, de manière à assurer une bonne efficacité de l'évacuation des charges du deuxième transistor.

Dans le cas où l'étage de commutation selon l'invention est mis en oeuvre en tant qu'étage de sortie des modules de sélection de lignes d'un décodeur de lignes d'une mémoire à n lignes comportant n modules de sélection délivrant chacun un signal logique de sortie, le signal logique de sortie d'un desdits modules sélectionné par une adresse introduite dans le décodeur étant à son niveau haut et les signaux logiques de sortie des (n−1) autres modules à leur niveau bas, l'invention se caractérisé en ce que le signal logique de sortie de chacun des modules est introduit à l'entrée d'un étage tel que défini ci-dessus et sa sortie est connectée à un conducteur de sélection de lignes de la mémoire.

L'invention sera mieux comprise à la lecture de la description qui va suivre donnée à titre d'exemple non limitatif en liaison avec les dessins qui représentent:

—la figure 1, un mode de réalisation de l'invention dans un décodeur de lignes d'une mémoire

—les figures 2a et 2b, les deux modes de courant dans les deux branches du circuit selon l'invention respectivement pour une ligne sélectionnée et une ligne non sélectionnée.

—les figures 3a et 3b les allures de courbes de chute de courant en différents points du Darlington selon que celui-ci est respectivement dépourvu et pourvu du circuit selon l'invention.

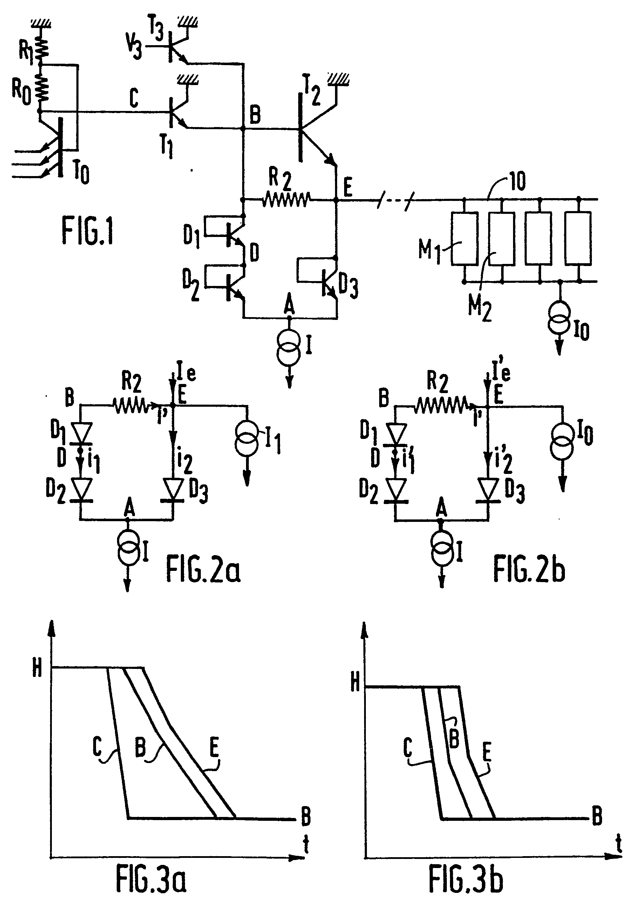

La figure 1 représente un module de décodage de l'adresse d'une ligne donnée d'une mémoire. Il y a autant de modules que de lignes dans la mémoire. Le décodage est du type à diodes et est réalisé par un transistor NPN multi-émetteurs $T_0$ dont la base est couplée au collecteur, soit directement soit comme représenté à travers une résistance $R_0$, une résistance $R_1$ étant disposée entre le collecteur de $T_0$ et la masse, en série avec la résistance $R_0$ si celle-ci est présente. Les émetteurs du transistor $T_0$ sont connectés de manière connue à des lignes d'adressage, de telle sorte que le transistor $T_0$ puisse reconnaître une adresse affichée à l'entrée du décodeur et correspondant à la sélection de ladite ligne. Lorsque ladite ligne est ainsi sélectionnée, le transistor $T_0$ est bloqué et aucun courant ne passe dans les résistances $R_0$ et $R_1$. Le collecteur du transistor $T_0$ est alors au potentiel de la masse (niveau haut). Pour toutes les autres adresses, qui correspondent aux cas où ladite ligne est non-sélectionnée, le transistor $T_0$ est passant par un moins un de ses émetteurs et est traversé par un courant I déterminé. Le collecteur du transistor $T_0$ se trouve alors au potentiel $-(R_0+R_1)$ I (niveau bas).

Comme la ligne sélectionnée de la mémoire consomme un courant relativement important, on utilise généralement pour chaque module en étage de sortie comprenant deux transistors NPN $T_1$ et $T_2$ montés en Darlington, le transistor d'entrée $T_1$ ayant sa base connectée au collecteur du transistor $T_0$ et son collecteur à la masse, et le transistor de sortie $T_2$, de grandes dimensions relativement à $T_1$, ayant son collecteur connecté à la masse et sont émetteur au conducteur de ligne 10 correspondant de la mémoire.

Lorsque la ligne est sélectionnée, celle des mémoires $M_1$, $M_2$ . . . qui est sélectionnée par des conducteurs de colonne est traversée par un courant de sélection relativement important, et les autres cellules par un courant de maintien $I_0$. L'étage de sortie doit fournir un courant $I_1$ relativement important, par exemple 5600 microampères.

Lorsque la ligne n'est pas sélectionnée, les cellules sont traversées seulement par le courant de maintien $I_0$ relativement faible par exemple 300 microampères fournis à la ligne par une source de courant appropriée.

On notera par ailleurs qu'en général on dispose entre la base et l'émetteur de $T_2$ une résistance $R_2$ choisie de manière à être traversée par une fraction du courant $I_0$.

Lors d'une commutation, une des lignes non-sélectionnées passe au mode sélectionné, alors que la ligne sélectionnée doit se désélectionner. Cette désélection a pour effet que le transistor de sortie $T_2$ voit son courant chuter de $I_1$ à $I_0$. La montée en courant se fait plus rapidement que la chuate de courant, celle-ci étant notamment freinée par l'accumulation de charges dans la base du transistors $T_2$, lquel est de grandes dimensions pour pourvoir fournir le courant $I_1$.

L'invention consiste ainsi en un aiguillage pour un courant auxiliaire propre à réaliser ladite évacuation des charges de la base du transistor $T_2$ dans la structure connue décrite ci-dessus.

Cet aiguillage de courant comporte une première branche comprenant en série deux diodes $D_1$ et $D_2$ disposées en série et dans le sens direct entre la base du transistor $T_2$ et la source de courant auxiliaire I (point A) et une deuxième branche comprenant une diode $D_3$ disposée dans le sens direct entre l'émetteur du transistor $T_2$ et la source de courant auxiliaire I (point A).

Ces diodes peuvent être avantageusement constituées par la jonction émetteur-base de transistors NPN de dimensions voisines de celles du transistor $T_1$, dont la base et le collecteur sont court-circuités et dont les émetteurs sont disposés en direction de la source de courant auxiliaire I.

Les figures 2a et 2b permettent d'illustrer la répartition du courant entre les deux branches de l'aiguillage respectivement lorsque la ligne représentée est sélectionnée au non.

Dans la suite de la description, C désigne le point commun au collecteur de $T_0$ et à la base de $T_1$, B le point commun à l'émetteur de $T_1$ et à la base de $T_2$, et E la sortie d'émetteur de $T_2$, connectée au conducteur de ligne 10. Le point D désigne le point commun aux diodes $D_1$ et $D_2$.

Dans l'état sélectioné (fig. 2a) l'émetteur de $T_2$ est traversé par un courant $I_e$, la première branche $D_1$, $D_2$ par un courant $i_1$, la deuxième branche $D_3$ par un courant $i_2$, et la ligne de mémoire est traversée par uncourant $I_1$. L'équilibre des courants aux points A et E donne les relations suivantes:

$$I_e+i'=I_1+i_2 \text{ et } i_1+i_2=I.$$

avec $i'=V_{BE}/R_2$ avec $V_{BE} \simeq 0,8$ V pour un transistor bipolaire.

$T_2$ est traversé par un courant relativement important. Sa chute de tension base-émetteur est donc importante, et surtout, elle est plus importante que celle aux bornes de $D_1$ qui ne peut être parcouru que le courant I fourni par la source de courant auxiliaire que l'on choisit largement inférieur à $I_1$. La condition à remplir peut s'exprimer approximativement en posant que la chute de tension base-émetteur de $T_2$ lorsqu'il est parcouru par du courant $I_1$ est supérieure à celle dans la diode $D_1$ lorsqu'elle est parcourue par le courant I. On peut jouer surtout sur la dimension relative des émetteurs de $D_1$ et de $T_2$, la valeur du courant I étant essentiellement choisie pour son aptitude à évacuer les charges accumulées dans la base de $T_2$.

Le potentiel au point E est dès lors plus faible qu'au point D. Comme $D_2$ et $D_3$ ont des caractéristiques courant-tension similaires, il en résulte que le courant $i_1$ est supérieur au courant $i_2$, dans un rapport $2^n$ si la différence de tension entre D et E est de $n \times 18$ mV. Donc, lorsque la ligne est à l'état sélectionné, le courant auxiliaire I est dirigé vers la première branche $D_1$, $D_2$.

A titre d'exemple, on prend $R_2=4$ k$\Omega$, d'où $i'=200$ microampères, $I_1=5600$ microampères, $I=700$ microampères. $D_1$ et $T_2$ sont dimentionnés de telle sorte que, dans ces conditions $i_1=600$ microampères et $i_2=100$ microampères. On a alors $I_e=5500$ microampères. Dans cet exemple, $i_1$ est légèrement supérieur au dizième de $I_c$.

Lorsque la ligne se désélectionne en réponse à un changement d'adresse à l'entrée du décodeur, le courant $i_1$ est mis à profit pour décharger les charges accumulées dans la base du transistor $T_2$, ce qui augmente la rapidité de la commutation.

Les figures 3a et 3b illustrent ce phénomène. Sur ces figures, on a figuré les variations des tensions aux points C, B et E en se remenant à un même niveau de tension. En fait, les points B et E sont respectivement plus bas de 800 mV environ que les points C et B.

A la figure 3a, (art antérieur) la chute de tension au point C est rapide, mais par contre celle au point B est beaucoup plus lente. La chute de tension au point E suit celle au point B avec un léger décalage temporel. L'aire comprise entre les courbes aux points B et C est représentative de l'effet négatif du stockage des charges dans la base du transistor $T_2$.

A la figure 3b, au contraire le courant $i_1$ permet d'accélérer la chute de tension au point B, celle-ci s'opérant maintenant pratiquement avec la même pente qu'au point C. La chute de tension au point E suit comme précédemment celle au point B. On gagne donc en temps de commutation lors de la désélection, ce qui diminue le temps d'accès de la mémoire.

La figure 2b représente le cas où la ligne est non-sélectionnée. L'émetteur de $T_2$ est traversé par un courant $I'e$ et les deux branches respectivement par des courant $i'_1$ et $i'_2$. Comme précédemment, on a les relations:

$$I'_e + i' = I_0 + i'_2 \text{ et } i'_1 + i'_2 = I.$$

$T_2$ étant en transistor de grandes dimensions, sa chute de tension base-émetteur $V_{BE}$ est plus faible à courant égal que dans la diode $D_1$. De ce fait, la situation est inversée par rapport au cas précédent et la tension au point E est légèrement supérieure à celle du point D. La majeure partie du courant auxiliaire I passe dans la diode $D_3$ qui constitue la deuxième branche de l'aiguillage. Par exemple, avec $I_0 = 300$ microampères et les mêmes autres paramètres que précédemment, on a $i'_1 = 200$ microampères, $i'_2 = 500$ microampères, et donc $I'e = 600$ microampères.

En mode non sélectionné,

$$I'e = (I_0 - i') + i'_2$$

alors qu'en l'absence du circuit d'aiguillage de courant selon l'invention, on aurait $I'e = E_0 - i'$, à savoir 100 microampères dans l'exemple précité.

Par conséquent, avec le circuit d'aiguillage selon l'invention, la chute de tension base-émetteur du transistor $T_2$ en mode non-sélectionné est nettement plus importante que dans l'art antérieur, ce qui diminue la tendance du transistor de sortie $T_2$ à rapprocher le niveau bas et le niveau haut.

Supposons que le niveau haut $H_B$ au point B est à −800 mV et le niveau bas $B_B$ à −2000 mV, soit un écart nominal de 1200 mV. Avec le circuit de l'art antérieur, le courant traversant la transistor en mode sélectionné est 5400 microampères et 100 microampères en mode non sélectionné, soit un rapport 1 à 54. L'écart entre les niveaux haut $E_H$ et bas $E_B$ au point H est réduit de 105 mV par rapport à l'écart nominal, et a donc pour valeur 1095 mV.

Avec le circuit selon l'invention, le rapport entre le courant traversant l'émetteur de $T_2$ en mode sélectionné et non sélectionné est nettement plus faible. Pour l'exemple ci-dessous, le courant d'émetteur $I_e$ en mode sélectionné à pour valeur 5500 microampères et le courant $I'e$ en mode

non-sélectionné a pour valeur 600 microampères, soit un rapport de 1 à 9,2 environ, soit une réduction de l'écart nominal de 58 mV seulement lequel a dans ce cas pour valeur 1142 mV.

Selon l'invention, on peut mettre en oeuvre (fig. 1) un transistor $T_3$ dont l'émetteur est au point B dont le collecteur à la masse et dont la base reçoit une tension de référence $V_3$. Cette tension de référence $V_3$ est commune à toutes les lignes et a un niveau tel qu'elle évite au moins dans une large mesure les rebondissements indésirables de la tension du niveau de non sélection pouvant intervenir sur les étages non-sélectionnés et qui restent non-sélectionnes lors d'un changement d'adresse, correspondant par exemple au changement de ligne d'une mémoire. La mise en oeuvre d'une telle tension de référence figure dans la demande de brevet français déposée le même pour que la présente demande par la Demanderesse et intitulée "Décodeur à diodes notamment utilisable dans une mémoire bipolaire".

L'invention ne se limite pas au mode de réalisation décrit et représenté. Elle peut être mise en oeuvre dans tout étage de commutation présentant un régime de courant fort et un régime de courant faible nettement différenciés. Dans le cas de sa mise en oeuvre dans un décodeur de lignes d'une mémoire à raison d'un étage de commutation par ligne, on notera que la nécessité d'utiliser une source de courant auxiliaire par ligne le destine plus particulièrement aux mémoires rapides présentant un nombre réduit de lignes (jusqu'à 10 environ).

## Revendications

1. Etage de commutation du type Darlington comportant un premier transistor ($T_1$) dont la base qui constitue l'entrée de l'étage est susceptible de recevoir un signal logique (C) de commande dont la tension varie entre un niveau dit de sélection et un niveau dit de non sélection, et dont l'émetteur attaque la base d'un deuxième transistor ($T_2$) dont l'émetteur, qui constitue la sortie (E) de l'étage est susceptible d'être relié à une première source de courant ($I_1$) lorsque ledit signal logique de commande est à son niveau de sélection et à une deuxième source de courant ($I_0$) d'intensité plus faible que la première lorsque ledit signal logique de commande est à son niveau de non-sélection caractérisé en ce qu'entre la base du deuxième transistor ($T_2$) et une source de courant auxiliaire (I) d'intensité comprise entre celle des deux premières sources de courant ($I_0$, $I_1$) sont disposées une première ($D_1$) et une deuxième ($D_2$) diode en série et dans le sens direct constituant une première branche et en ce qu'entre l'émetteur du deuxième transistor ($T_2$) et ladite source de courant auxiliaire (I), est disposée une troisième diode ($D_3$) dans le sens direct constituant une deuxième branche de telle sorte que, lors de la commutation du signal de commande entre son niveau de sélection et de non-sélection, les charges stockées dans la base (B) du

second transistor ($T_2$) soient évacuées par le courant de la source de courant auxiliaire (I) dont la majeure partie passe dans la première branche ($D_1$, $D_2$).

2. Etage de commutation selon la revendication 1, caractérisé en ce que le deuxième transistor ($T_2$) comporte entre son émetteur et sa base une résistance ($R_2$) dont la valeur est telle que le courant qui la traverse a pour valeur une fraction du courant de la troisième source de courant ($I_0$).

3. Etage de commutation selon une des revendications 1 ou 2, caractérisé en ce que le courant de la source de courant auxiliaire (I) est supérieur ou égal à 10% du courant de la deuxième source.

4. Etage de commutation selon une des revendications 1 à 3, caractérisé en ce qu'au moins une desdites diodes ($D_1$, $D_2$, $D_3$) est constituée par la jonction émetteur-base d'au moins un troisième transistor dont la base et le collecteur sont court-circuités.

5. Etage de commutation selon une des revendications précédentes caractérisé en ce qu'il comporte un quatrième transistor ($T_3$) dont l'émetteur attaque la base du deuxième transistor ($T_2$) et dont la base reçoit une tension de référence ($V_3$) dont la valeur est telle qu'elle évite au moins dans une large mesure des rebondissements du niveau de non-sélection lors d'un changement d'adresse.

## Patentansprüche

1. Schaltstufe vom Darlington-Typ mit einem ersten Transistor (T1), dessen Basis als Stufeneingang zum Empfangen eines logischen Steuersignals (C) geeignet ist, dessen Spannung zwischen einem mit Wahlpegel bezeichneten Pegel und einem mit Nichtwahlpegel bezeichneten Pegel liegt und dessen Emitter die Basis eines zweiten Transistors (T2) ansteuert, dessen Emitter als Stufenausgang (E) sich zum Anschließen an eine erste Stromquelle (I1), wenn das logische Steuersignal auf seinem Wahlpegel liegt, und an eine zweite Stromquelle (I0) eignet, deren Stärke geringer als die der ersten Quelle ist, wenn das logische Steuersignal auf seinem Nichtwahlpegel liegt, dadurch gekennzeichnet, daß zwischen der Basis des zweiten Transistors (T2) und einer Hilfsstromquelle (I) mit einer Stromstärke zwischen denen der zwei ersten Stromquellen (I0, I1) eine erste (D1) und eine zweite Diode (D2) in Reihe und in Durchlaßrichtung zur Bildung eines ersten Abzweigs geschaltet sind, und daß zwischen dem Emitter des zweiten Transistors (T2) und der Hilfsstromquelle (I) eine dritte Diode (D3) in der Durchlaßrichtung zum derartigen Bilden eines zweiten Abzweigs angeordnet ist, daß beim Umschalten des Steuersignals zwischen seinem Wahlpegel und seinem Nichtwahlpegel die in der Basis (B) des zweiten Transistors (T2) gespeicherten Ladungen durch den Strom der Hilfsstromquelle (I) abgegriffen werden, dessen Hauptanteil an den ersten Abzweig (D1, D2) gelangt.

2. Schaltstufe nach Anspruch 1, dadurch gekennzeichnet, daß der zweite Transistor (T2) zwischen seinem Emitter und seiner Basis einen Widerstand (R2) enthält, dessen Wert derart ist, daß der den Widerstand durchfließende Strom einen Bruchteil des Stromes der dritten Stromquelle (I0) beträgt.

3. Schaltstufe nach Anspruch 1 oder 2, dadurch gekennzeichnet, daß der Strom der Hilfsstromquelle (I) höher oder gleich 10% des Stromes der zweiten Quelle ist.

4. Schaltstufe nach Anspruch 1 bis 3, dadurch gekennzeichnet, daß wenigstens eine der Dioden (D1, D2, D3) durch den Emitter-Basis-Übergang wenigstens eines dritten Transistors gebildet wird, dessen Basis und dessen Kollektor kurzgeschlossen sind.

5. Schaltstufe nach einem der vorangehenden Ansprüche, dadurch gekennzeichnet, daß darin ein vierter Transistor (T3) vorgesehen ist, dessen Emitter die Basis des zweiten Transistors (T2) ansteuert und dessen Basis eine Bezugsspannung (V3) empfängt, deren Wert derart ist, daß er bei einer Adreßänderung wenigstens weitgehend Anstiegserscheinungen im Nichtwahlpegel unterdrückt.

## Claims

1. A Darlington-type switching stage, comprising a first transistor ($T_1$) whose base, constituting the input of the stage, is adapted to receive a logic control signal (C) whose voltage varies between a so-called selection level and a so-called non-selection level, and whose emitter acts upon the base of a second transistor ($T_2$) whose emitter, constituting the output (E) of the stage, is adapted to be connected to a first current source ($I_1$) when said logic control signal is at its selection level, and to a second current source ($I_0$) of lower intensity than the first source when said logic control signal is at its non-selection level, characterized in that between the base of the second transistor ($T_2$) and an auxiliary current source (I) whose intensity lies between the intensities of the two first current sources ($I_0$, $I_1$), a first diode ($D_1$) and a second diode ($D_2$) are connected in series in the forward direction, which diodes constitute a first branch, and in that between the emitter of the second transistor ($T_2$) and said auxiliary current source (I) a third diode ($D_3$) is connected in the forward direction so as to constitute a second branch in such a manner that upon switching of the control signal between its selection level and its non-selection level, the charges stored in the base (B) of the second transistor ($T_2$) are depleted by the current of the auxiliary current source (I) which passes for the major part through the first branch ($D_1$, $D_2$).

2. A switching stage as claimed in Claim 1, characterized in that the second transistor ($T_2$) comprises, connected between its emitter and its base, a resistance ($R_2$) whose value is such that the current traversing it has a value equal to a fraction of the current of the third current source ($I_0$).

3. A switching stage as claimed in any one of Claims 1 or 2, characterized in that the current of the auxiliary current source (I) is larger than or equal to 10% of the current of the second source.

4. A switching stage as claimed in any one of Claims 1 to 3, characterized in that at least one of said diodes ($D_1$, $D_2$, $D_3$) is constituted by the emitter-base junction of at least one third transistor whose base and collector are shortcircuited.

5. A switching stage as claimed in any one of the preceding Claims, characterized in that it comprises a fourth transistor ($T_3$) whose emitter acts upon the base of the second transistor ($T_2$) and whose base receives a reference voltage ($V_3$) whose value is such that it avoids at least to a greater extent surges of the non-selection level during a change of address.

FIG.1

FIG.2a

FIG.2b

FIG.3a

FIG.3b